# FASCICULE DE BREVET EUROPEEN

(11) **EP 1 577 690 B1**
(45) Date de publication et mention de la délivrance du brevet: **27.02.2008**
(21) Numéro de dépôt: 05102029.5
(22) Date de dépôt: 15.03.2005
(51) Int. Cl.: G02B 6/43, G02B 6/122, G02B 6/132

(54) **Fabrication d'une couche d'interconnéction optique sur un circuit**
Herstellung einer optischen Verbindungsschicht auf einem elektronischen Schaltkreis
Fabrication of an optical interconnection layer on an electronic circuit

(30) Priorité: 17.03.2004 FR 0450535
(43) Date de publication de la demande: 21.09.2005
(73) Titulaire: COMMISSARIAT A L'ENERGIE ATOMIQUE, 75015 Paris (FR)
(72) Inventeur: Fedeli, Jean-Marc, 38120, Saint Egreve (FR); Di Cioccio, Léa, 38330, Saint Ismier (FR)
(74) Mandataire: Poulin, Gérard

(56) Documents cités:
- EP-A- 1 041 418
- WO-A-20/04010192
- GEORGAKILAS A ET AL: "WAFER-SCALE INTEGRATION OF GAAS OPTOELECTRONIC DEVICES WITH STANDARD SI INTEGRATED CIRCUITS USING A LOW-TEMPERATURE BONDING PROCEDURE" APPLIED PHYSICS LETTERS, vol. 81, no. 27, 30 décembre 2002 (2002-12-30), pages 5099-5101, XP001144665 ISSN: 0003-6951

## Description

### DOMAINE TECHNIQUE ET ART ANTERIEUR

L'invention concerne le domaine des dispositifs optoélectroniques, notamment celui de la photonique sur silicium, et en particulier la réalisation d'interconnections optiques sur puce de silicium pour la distribution de signaux intra puces.

Elle se rapporte aussi aux techniques de guidage de lumière dans des guides à fort indice, dans des dimensions nanométriques.

L'invention s'applique notamment au domaine des interconnections optiques, des connections optiques intra puces, des télécommunications optiques, des capteurs optiques intégrés.

Par les techniques de type « photonique sur silicium », on cherche à réaliser des fonctions optiques à forte intégration sur silicium.

Dans une approche générale, on dispose d'émetteurs couplés à un ensemble de guides, cet ensemble réalisant une fonction optique, soit passivement, soit en fonction d'une commande électrique.

Ces guides aboutissent à des photodétecteurs qui délivrent électriquement le résultat de la fonction optique.

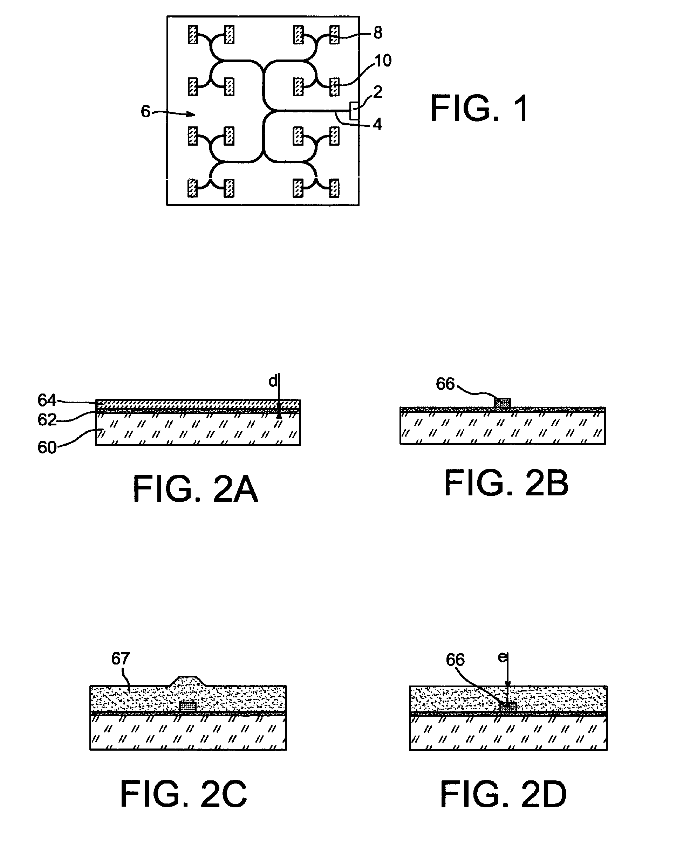

Pour distribuer un signal optique sur la puce, comme par exemple dans le cas d'une distribution optique d'horloge, la fonction optique prend la forme d'un arbre constitué de diviseurs et de virages. Le système optique complet, illustré sur la figure 1, se compose alors des éléments suivants :
- un émetteur 2 de lumière (diode électroluminescente ou diode laser) couplé à un guide 4 submicronique à fort indice,
- un arbre 6 de distribution,
- des photodétecteurs 8, 10 couplés en bout de chaque extrémité d'arbre.

Le document de A.Georgalikas et al. intitulé « Wafer scale integration of GaAs optoelectronic devices with standard Si integrated circuits using a low-temperature bonding procedure », Applied Physics Letters, Vol.81, Nr 27, Dec.2002 décrit un procédé de réalisation d'un dispositif optoélectronique comportant une étape de collage sur un circuit CMOS planarisé d'une plaque contenant des hétérostructures AsGa. Ce collage se fait par SOG. Puis le substrat AsGa est éliminé. Les étapes de formation du guide et de métallisation, pour la diode laser et le photodétecteur sont réalisés dans les couches de l'hétérostructure. Ce procédé ne permet pas de découpler la partie guidage optique de la partie optoélectronique (cette dernière comportant émission et photodétection). Cela exclut notamment l'utilisation de guides en silicium.

On cherche actuellement d'autres types de procédés permettant de réaliser des composants optoélectroniques comportant une partie de guidage optique, des moyens optiques actifs, tels qu'émetteurs et détecteurs, et un substrat électronique ou comportant un ou plusieurs composants électroniques, tel que par exemple un circuit CMOS.

Le document WO 2004/010192 décrit un procédé de réalisation d'un dispositif optoélectrique prévoyant l'étape de fabrication de moyens optiquement actifs dans une couche superficielle. Mais aucun détail n'est donné sur cette étape.

Il se pose donc le problème de trouver d'autres procédés de réalisation de tels composants.

Encore un autre problème est celui du couplage électromagnétique entre les moyens de guidage optique et les moyens optiquement actifs tels que le ou les photodétecteur(s) et/ou le ou les émetteur(s).

### EXPOSÉ DE L'INVENTION

L'invention a pour but de résoudre les difficultés présentées ci dessus en simplifiant la fabrication.

L'invention concerne d'abord un procédé de réalisation d'un dispositif optoélectronique, comportant :
a - une étape de réalisation de moyens de guidage optique, dans une couche superficielle d'un substrat composite, comportant un substrat support, une couche intermédiaire en oxyde, dont le matériau a un indice inférieur à celui de la couche superficielle, et la couche superficielle,
b - une étape d'assemblage de ces moyens avec des moyens de circuit électronique,
c - une étape d'élimination du substrat support,
d - la formation de moyens optiquement actifs par dessus cet assemblage sur la couche intermédiaire, ladite couche intermédiaire ayant une épaisseur permettant d'assurer un bon couplage électromagnétique entre les moyens optiquement actifs et les moyens de guidage.

Ce procédé met en oeuvre un nombre réduit d'étapes technologiques.

L'assemblage préalable de la couche comportant des moyens de guidage optique, ou d'une couche contenant ces moyens de guidage, avec le circuit électronique permet notamment un contrôle aisé de la distance entre les moyens de guidage et les moyens optiquement actifs.

Le substrat support est réalisé par exemple en un matériau semi-conducteur, notamment en silicium, la couche intermédiaire en oxyde (notamment un oxyde du matériau semi-conducteur du substrat support) a par exemple un indice optique, typiquement inférieur à 1,6.

Le substrat composite est par exemple de type SOI avec un substrat support en silicium, une couche d'oxyde thermique qui correspond à la couche intermédiaire de bas indice optique et une couche superficielle en silicium monocristallin.

La couche superficielle peut être en polymère ou en nitrure ou en silicium polycristallin.

La couche d'oxyde peut avoir une épaisseur comprise entre 50 nm et 1 µm, avantageusement entre 50 nm et 400 nm.

L'étape b) peut être réalisée par adhésion moléculaire ou par procédé SOG (« spin on glass ») ou par collage à l'aide d'un polymère, par exemple BCB ou par collage métallique ou eutectique.

Les moyens optiquement actifs peuvent être des matériaux de type III - V. Ces moyens comportent par exemple un ou plusieurs émetteurs lasers et/ou un ou plusieurs détecteurs de rayonnement.

L'étape d) peut comprendre une étape d'assemblage par adhésion moléculaire.

Plus précisément, selon un mode de réalisation, l'étape d) comporte :
d1- un assemblage d'un substrat composite avec l'assemblage des moyens de guidage optique avec les moyens de circuit électronique, cette étape pouvant être obtenue par assemblage par adhésion moléculaire,
d2- une formation des moyens optiquement actifs dans le substrat composite.

Les moyens optiquement actifs peuvent être réalisés par gravure du substrat composite.

Le procédé peut en outre comporter une étape d'encapsulation dans une couche du matériau constitutif de la couche intermédiaire, à bas indice optique, par exemple une couche d'oxyde, tel que par exemple de l'oxyde de silicium.

L'invention permet d'obtenir une distance d très faible (par exemple de l'ordre de 100 nm), entre le guide et la surface supérieure de cette couche de matériau à bas indice comprise, distance d qui peut être contrôlée à +/- 10 nm sur toute la plaque dans le cas d'un oxyde thermique. On obtient ainsi un bon couplage électromagnétique entre les moyens de guidage optique et les moyens optiquement actifs tels que le ou les photodétecteur(s) et/ou le ou les émetteur(s).

L'invention concerne également un dispositif optoélectronique, comportant des moyens de guidage optique, compris entre des moyens de circuit électronique, et des moyens optiquement actifs.

Une couche intermédiaire d'oxyde, en un matériau à bas indice optique, typiquement inférieur à 1,6, sépare les moyens de guidage optique et les moyens optiquement actifs. L'épaisseur de la couche d'oxyde est telle qu'elle permet d'assurer un bon couplage électromagnétique entre les moyens de guidage optique et les moyens optiquement actifs. La couche intermédiaire a une épaisseur comprise entre 50 nm et 1 µm, avantageusement entre 50 nm et 200 nm ou entre 50 nm et 400 nm.

De préférence une distance d'au moins 1 µm sépare les moyens de guidage optique et les moyens de circuit électronique.

Les matériaux constitutifs de ce dispositif sont ceux déjà mentionnés en liaison avec le procédé ci-dessus.

### BRÈVE DESCRIPTION DES DESSINS

- La figure 1 représente un dispositif connu,
- les figures 2A - 2I représentent des étapes d'un procédé selon l'invention,
- les figures 3A - 3H représentent des étapes de réalisation de sources de rayonnement avec une plaque sur substrat InP.

### DESCRIPTION DE MODES PARTICULIERS DE REALISATION

Un exemple d'un procédé selon l'invention est illustré sur les figures 2A - 2I.

Une plaque SOI de départ est composée d'un substrat Silicium 60 surmonté d'un oxyde thermique 62 dont l'épaisseur a une valeur proche de la valeur désirée, par exemple dans la gamme 50 nm - 1µm, avantageusement entre 50 nm et 400 nm, pour la distance d entre le guide optique et les moyens optiquement actifs.

A titre d'exemple, la plaque SOI a une couche 62 d'épaisseur d égale à environ 100 nm, avec une uniformité de +/- 10 nm.

La couche de silicium 64 a, quant à elle, une épaisseur comprise entre par exemple 100 nm et 500 nm (figure 2A).

Des moyens de guidage optique 66 sont ensuite réalisés par photolithographie et gravure (figure 2B) dans la couche 64. Ces moyens sont vus en coupe sur la figure 2B et peuvent se prolonger perpendiculairement au plan de cette figure. En outre seul un guide est représenté sur la figure 2B, mais un réseau de guides tel que celui de la figure 1 peut aussi être réalisé.

On réalise alors un dépôt d'une couche 67 de silice, par exemple par PECVD.

Cette couche 67 permet d'encapsuler le guide ou les moyens de guidage dans un matériau à faible indice.

On réalise un polissage mécanochimique afin d'obtenir une surface plane (figure 2D).

De préférence, l'épaisseur e au-dessus du guide 66 est supérieure à 1 µm, afin d'éviter des pertes optiques après assemblage.

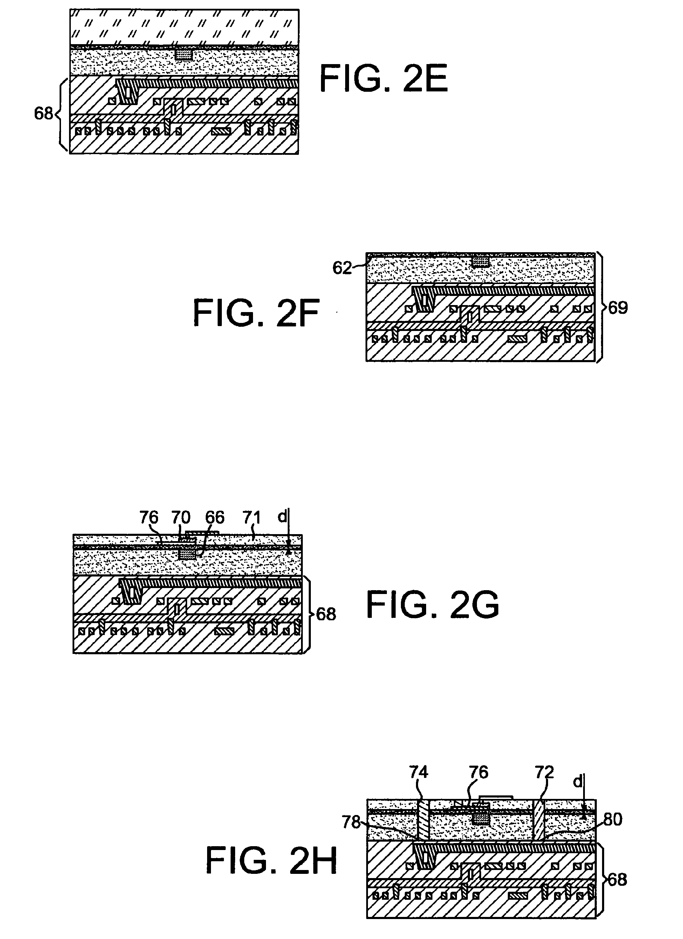

Ce substrat comportant les guides optiques 66 est alors collé sur une plaque 68 contenant des circuits électroniques, par exemple de type CMOS (figure 2E). Le collage peut être réalisé par adhérence moléculaire, ou par d'autres types de collage, par exemple par SOG (abréviation de l'expression anglosaxonne « spin on glass ») ou par l'intermédiaire d'un polymère, par exemple du BCB ou par collage métal eutectique.

On élimine alors le substrat 60 de silicium jusqu'à la surface de la couche 62 (figure 2F). On obtient un composant optoélectronique 69.

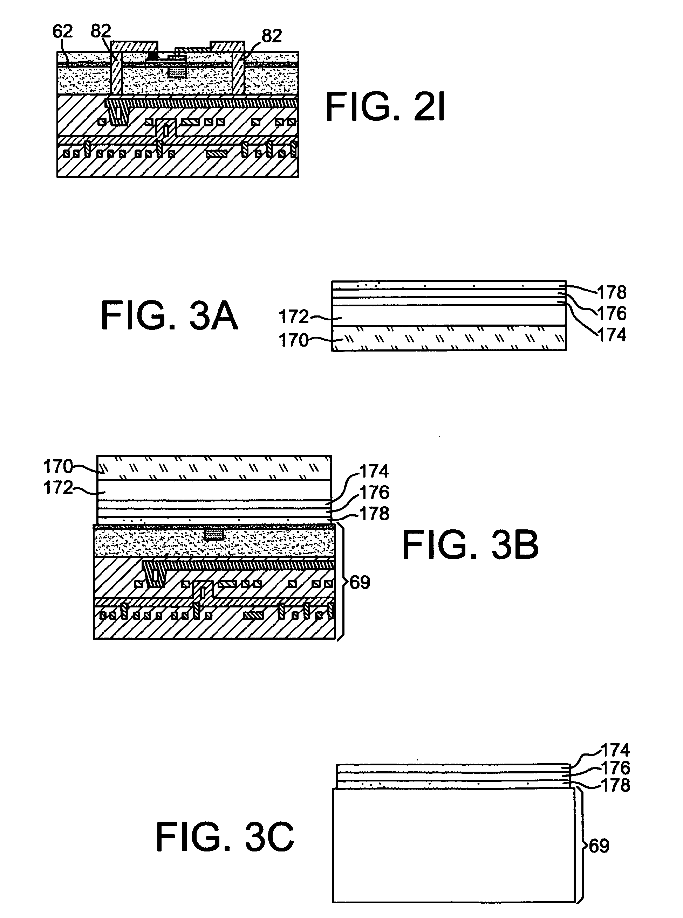

On réalise alors l'assemblage de composants optiques actifs 70, par exemple par adhésion moléculaire. Les composants 70, au moins une source lumineuse telle que par exemple un émetteur laser et/ou un ou plusieurs photodétecteurs, sont par exemple en matériaux III-V. Un exemple de réalisation de tels composants 70 sera décrit plus en détail en liaison avec les figures 3A - 3H.

Il peut ensuite y avoir lithographie et gravure de ces matériaux qui sont ensuite encapsulés (figure 2G) dans une couche 71, par exemple en silice.

On grave ensuite les différentes couches de silice (figure 2H) afin de réaliser des ouvertures 72, 74 sur les électrodes 76 et les parties métalliques 78, 80 de la plaque de circuits 68.

On connecte ensuite les électrodes et le circuit CMOS avec un dépôt métallique 82 (figure 2I).

Au final, l'assemblage des composants actifs (émetteurs et/ou photodétecteurs) a été réalisé sur la couche 62 d'oxyde. La distance d, entre le guide et les moyens optiquement actifs 70, est principalement définie par l'épaisseur de cette couche 62 d'oxyde : celle-ci peut être faible, par exemple de l'ordre de 70 nm à 420 nm.

Dans le cas d'un oxyde thermique, l'épaisseur d'oxyde peut être contrôlé quelque soit la valeur de la distance d avec une précision de +/-10 nm à l'échelle du substrat (8 pouces), ce qui permet d'assurer un couplage optimum sur toute l'étendue du substrat, assurant ainsi de bons rendements de fabrication, particulièrement avantageux dans le cadre d'un procédé industriel.

Une distance d faible, par exemple dans la gamme ci-dessus, permet d'assurer un bon couplage électromagnétique entre le guide et chaque photodétecteur ou émetteur concerné.

Si la distance d est encore trop importante, la couche 62 peut être amincie avec des techniques de gravure chimique ou plasma de la microélectronique (par exemple après l'étape de la figure 2F) qui permettent encore de retirer une faible épaisseur de silice, typiquement de l'ordre de 100 nm, avec une grande précision.

Autrement dit, l'assemblage préalable de la couche comportant les moyens de guidage optique avec le circuit électronique 68 permet un contrôle aisé de la distance d, avant assemblage avec les moyens optiquement actifs.

Dans le cas d'un report par adhésion moléculaire, tel celui de la figure 2E, il est avantageux de réaliser ce collage sur un oxyde thermique. En effet la qualité structurale de l'oxyde thermique permet d'obtenir un collage de très bonne qualité.

Les tolérances pour le dépôt d'oxyde 67 ainsi que pour le polissage de cette couche d'oxyde sont relaxées (épaisseur après polissage de préférence supérieure à 1 µm) et il n'y a pas besoin de contrôle d'épaisseur après polissage.

Selon ce procédé, le nombre d'étapes technologiques est réduit.

Les figures 3A - 3H illustrent un exemple de réalisation de composants optiques actifs à partir d'une plaque active comportant un substrat 170 en InP, une couche sacrificielle 172 en InGaAs, une hétérostructure 174 (c'est-à-dire un empilement de couches alternées de compositions différentes) d'épaisseur de l'ordre de quelques centaines de nm, par exemple comprise entre 300 nm et 700 nm, par exemple 500 nm, une zone de contact 176 (par exemple d'environ 100 nm d'épaisseur), et une couche en silice 178 (par exemple d'environ 10 nm d'épaisseur).

Cette plaque est assemblée (figure 3B) avec l'assemblage 69, illustré en figure 2F, déjà réalisé, des moyens de guidage et des composants électroniques. L'assemblage met en oeuvre un collage par adhésion moléculaire des deux plaques.

Il y a ensuite élimination du substrat 170 InP et de la couche sacrificielle 172 (figure 3C).

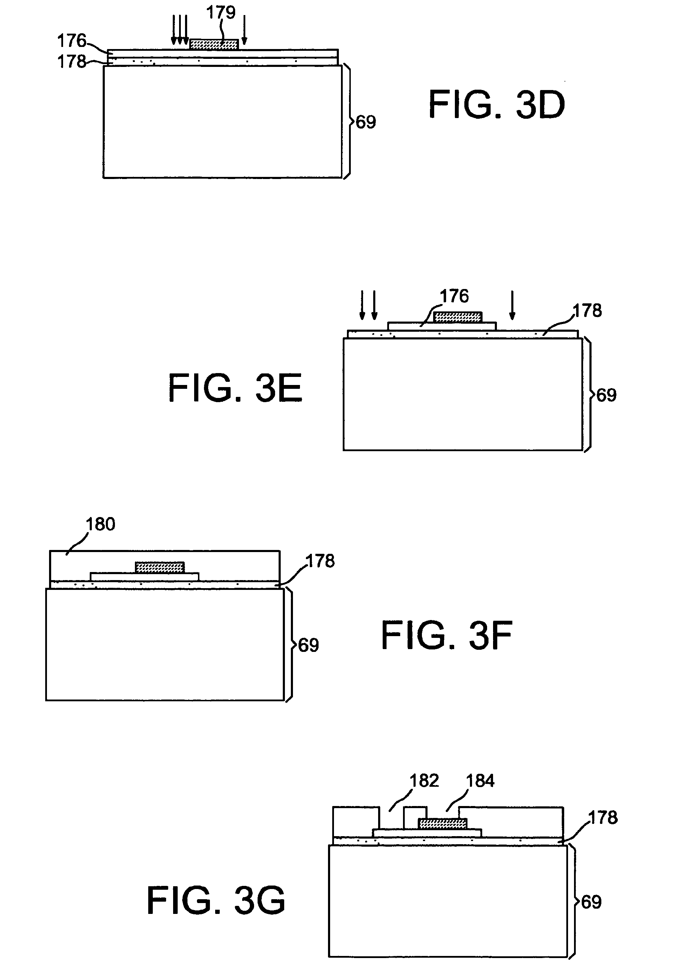

Il peut ensuite y avoir lithographie et gravure de l'hétérostructure 174 (figure 3D) de manière à former le composant 179 souhaité, par exemple un composant actif tel qu'une source lumineuse (diode laser ou microlaser) ou un détecteur.

Il est ensuite procédé à une lithographie et à une gravure de la couche 176 du contact inférieur (figure 3E).

Une étape de planarisation peut avoir ensuite lieu (figure 3F) par dépôt d'une couche 180 de polymère comme par exemple le BCB.

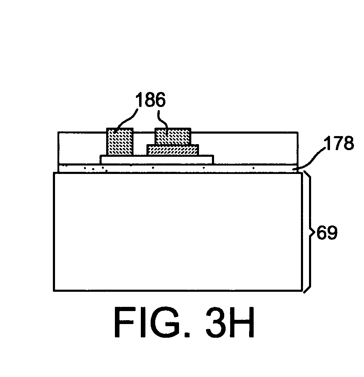

Puis on réalise des ouvertures 182, 184 dans cette couche (figure 3G), et des dépôts métalliques 186 pour les contacts inférieur et supérieur (figure 3H).

On obtient ainsi le dispositif illustré en figure 2G.

Malgré les couches 176 et 178, la distance entre le guide et les moyens optiquement actifs 179 reste aisément contrôlable du fait, comme déjà indiqué ci-dessus, de l'assemblage préalable de la couche comportant les moyens de guidage optique avec le circuit électronique.

L'exemple a été donné d'une couche 64 en silicium monocristallin, mais il peut s'agir d'une couche en un autre matériau, d'indice supérieur à celui de la couche d'oxyde 62, par exemple un polymère ou un nitrure ou une couche de silicium polycristallin.

## Revendications

1. Procédé de réalisation d'un dispositif optoélectronique, comportant:
a - une étape de réalisation de moyens (66) de guidage optique, dans une couche superficielle (64) d'un substrat composite, comportant un substrat support (60), une couche intermédiaire (62) en oxyde, dont le matériau a un indice optique inférieur à celui de la couche superficielle (64), et la couche superficielle.
b - une étape d'assemblage de ces moyens avec des moyens (68) de circuit électronique,
**caractérisé en ce que** le procédé comporte également
c - une étape d'élimination du substrat support (60)
d - la formation de moyens (70) optiquement actifs par dessus cet assemblage, sur la couche intermédiaire, ladite couche intermédiaire ayant une épaisseur permettant d'assurer un bon couplage électromagnétique entre les moyens optiquement actifs et les moyens de guidage.

2. Procédé selon la revendication 1, le substrat support étant en un matériau semi-conducteur.

3. Procédé selon la revendication 2, la couche intermédiaire, d'indice optique inférieur à celui de la couche superficielle, étant en un oxyde du matériau semi-conducteur.

4. Procédé selon la revendication 3, dans lequel la couche intermédiaire est en oxyde thermique.

5. Procédé selon l'une des revendications 1 à 4, la couche intermédiaire, d'indice optique inférieur à celui de la couche superficielle ayant un indice inférieur à 1,6.

6. Procédé selon l'une des revendications 1 à 5, le substrat composite étant de type SOI.

7. Procédé selon l'une des revendications 1 à 6, la couche superficielle (64) étant en polymère ou en nitrure ou en silicium polycristallin.

8. Procédé selon l'une des revendications 1 à 7, la couche intermédiaire (62) ayant une épaisseur comprise entre 50 nm et 1 µm, avantageusement entre 50 nm et 400 nm.

9. Procédé selon l'une des revendications 1 à 8, comportant en outre une étape d'encapsulation dans une couche du matériau de la couche intermédiaire.

10. Procédé selon l'une des revendications 1 à 9, l'étape b) étant réalisée par adhésion moléculaire ou par procédé SOG ou par l'intermédiaire d'un polymère ou par collage métallique ou eutectique.

11. Procédé selon l'une des revendications 1 à 10, l'étape d) comprenant:
d1- un assemblage d'une plaque active avec l'assemblage formé des moyens (66) de guidage optique et des moyens (38) de circuit électronique,
d2- une formation des moyens (70) optiquement actifs dans la plaque active de cet assemblage.

12. Procédé selon la revendication 11, la plaque active comportant un empilement de matériaux III - V.

13. Procédé selon la revendication 11 ou 12, l'étape d1 étant obtenue par assemblage par adhésion moléculaire.

14. Procédé selon l'une des revendications 11 à 13, les moyens (70) optiquement actifs étant réalisés par gravure dans la plaque active.

15. Dispositif optoélectronique, comportant des moyens (66) de guidage optique, compris entre des moyens (68) de circuit électronique, et des moyens (70) optiquement actifs, une couche (62) intermédiaire d'oxyde, d'indice inférieur à l'indice du matériau constitutif des moyens de guidage optique, étant comprise entre ces moyens (66) de guidage optique et les moyens (70) optiquement actifs, **caractérisé en ce que** l'épaisseur de la couche d'oxyde est comprise entre 50 nm et 1µm, permettant d'assurer un bon couplage électromagnétique entre les moyens de guidage optique (66) et les moyens optiquement actifs (70) .

16. Dispositif selon la revendication 15, l'indice de la couche intermédiaire étant inférieur à 1,6 .

17. Dispositif selon la revendication 15 ou 16, dans lequel l'oxyde de la couche intermédiaire est un oxyde thermique.

18. Dispositif selon l'une des revendications 15 à 17, la couche intermédiaire ayant une épaisseur comprise entre 50 nm et 400 nm.

19. Dispositif selon l'une des revendications 15 à 18, une distance d'au moins 1 µm séparant les moyens de guidage optique et les moyens (68) de circuit électronique.

20. Dispositif selon l'une des revendications 15 à 19, les moyens (70) optiquement actifs étant en des matériaux de type III - V.

## Claims

1. Manufacturing method of an optoelectronic device, comprising:
a - a step for manufacturing optical guiding elements (66), in an superficial layer (64) of a composite substrate, comprising a support substrate (60), an oxide interlayer (62), whose material has a lower optical index than that of the superficial layer (64), and the superficial layer,
b - a step for assembling these elements with the electronic circuit means (68), **characterized in that** the method also comprises
c - a step for removing the support substrate (60),
d - the generating of optically active means (70) on top of this assembly, on the interlayer, said interlayer having a thickness ensuring proper electromagnetic coupling between the optically active means and the guiding elements.

2. Method as set forth in claim 1, the support substrate being made in a semiconductor material.

3. Method as set forth in claim 2, the interlayer, with a lower optical index than that of the superficial layer, being made in an oxide of the semiconductor material.

4. Method as set forth in claim 3, the interlayer, with a lower optical index than that of the superficial layer, being made in an oxide of the semiconductor material, said oxide being a thermal oxide.

5. Method as set forth in any one of the claims 1 to 4, the interlayer, with a lower optical index than that of the superficial layer having an index lower than 1.6.

6. Method as set forth in any one of the claims 1 to 5, the composite substrate being of SOI type.

7. Method as set forth in any one of the claims 1 to 6, the superficial layer (64) being made in a polymer or a nitride or a polycrystalline silicon.

8. Method as set forth in any one of the claims 1 to 7, the interlayer (62) having a thickness of between 50 nm and 1 µm, advantageously between 50 nm and 400 nm.

9. Method as set forth in any one of the claims 1 to 8, further comprising a step for packaging in a layer of the material of the interlayer.

10. Method as set forth in any one of the claims 1 to 9, the step b) being performed using molecular adhesion or via the SOG method or via a polymer or via metallic or eutectic bonding.

11. Method as set forth in any one of the claims 1 to 10, the step d) comprising:
d1 - an assembly of an active board with the assembly made of the optical guiding elements (66) and the electronic circuit means (38),
d2 - a generating of the optically active means (70) in the active board of this assembly.

12. Method as set forth in claim 11, the active plate having a stack of III-V materials.

13. Method as set forth in claim 11 or 12, step d1 being obtained by molecular adhesion assembly.

14. Method as set forth in claims 11 to 13, the optically active means being implemented by etching in the active plate.

15. Optoelectronic device, comprising optical guiding elements (66) held between the electronic circuit means (68) and the optically active means (70), an interlayer of oxide (62), with a lower index than the index of the constituent material of the optical guiding elements, being held between these optical guiding elements (66) and the optically active means (70), **characterized in that** the thickness of the layer of oxide being between 50 nm and 1 µm, such that it ensures proper electromagnetic coupling between the optical guiding elements (66) and the optically active means (70).

16. Device as set forth in claim 15, the index of the interlayer being less than 1.6.

17. Device as set forth in claim 15 or 16, in which the oxide of the interlayer is a thermal oxide.

18. Device as set forth in claim 15, the interlayer having a thickness between 50 nm and 400 nm.

19. Device as set forth in one of the claims 15 to 18, a distance of at least 1 µm separating the optical guiding elements and the electronic circuit means (68).

20. Device as set forth in one of the claims 15 to 19, the optically active means (70) being made in III-v type materials.

## Patentansprüche

1. Verfahren zum Herstellen eines optoelektronischen Bauelements umfassend:
a - einen Schritt der Herstellung von Mitteln (66) zur Lichtleitung in einer Oberflächenschicht (64) eines Verbundsubstrats, das ein Trägersubstrat (60), eine Oxidzwischenschicht (62), deren Material einen Brechungsindex unter dem der Oberflächenschicht (64) aufweist, und die Oberflächenschicht umfaßt, und
b - einen Schritt des Zusammenfügens dieser Mittel mit Mitteln (68) einer elektronischen Schaltung, **dadurch gekennzeichnet, daß** das Verfahren ferner
c - einen Schritt des Entfernens des Trägersubstrats (60) und
d - die Bildung optisch aktiver Mittel (70) oben auf dieser Anordnung auf der Zwischenschicht umfaßt, wobei die Zwischenschicht eine das Sicherstellen einer guten elektromagnetischen Kopplung zwischen den optisch aktiven Mitteln und den Mitteln zur Lichtleitung ermöglichende Dicke aufweist.

2. Verfahren gemäß Anspruch 1, wobei das Trägersubstrat aus einem Halbleitermaterial besteht.

3. Verfahren gemäß Anspruch 2, wobei die Zwischenschicht mit einem Brechungsindex unter dem der Oberflächenschicht aus einem Oxid eines Halbleitermaterials besteht.

4. Verfahren gemäß Anspruch 3, wobei die Zwischenschicht aus einem thermischen Oxid besteht.

5. Verfahren gemäß einem der Ansprüche 1 bis 4, wobei die Zwischenschicht mit einem Brechungsindex unter dem der Oberflächenschicht einen Brechungsindex unter 1,6 aufweist.

6. Verfahren gemäß einem der Ansprüche 1 bis 5, wobei das Verbundsubstrat vom SOI-Typ ist.

7. Verfahren gemäß einem der Ansprüche 1 bis 6, wobei die Oberflächenschicht (64) aus einem Polymer oder Nitrid oder polykristallinem Silizium besteht.

8. Verfahren gemäß einem der Ansprüche 1 bis 7, wobei die Zwischenschicht (62) eine Dicke zwischen 50 nm und 1 µm, vorteilhafterweise zwischen 50 nm und 400 nm aufweist.

9. Verfahren gemäß einem der Ansprüche 1 bis 8, das außerdem einen Schritt der Kapselung der Zwischenschicht in einer Materialschicht umfaßt.

10. Verfahren gemäß einem der Ansprüche 1 bis 9, wobei der Schritt b) durch molekulare Adhäsion oder durch das SOG-Verfahren oder mittels eines Polymers oder durch Metallkleben oder eutektisches Bonden durchgeführt wird.

11. Verfahren gemäß einem der Ansprüche 1 bis 10, wobei der Schritt d)
d1 - das Zusammenfügen eines aktiven Wafers mit der aus den Mitteln (66) zur Lichtleitung und den Mitteln (38) einer elektronischen Schaltung gebildeten Anordnung und
d2 - das Bilden der optisch aktiven Mittel (70) in dem aktiven Wafer dieser Anordnung umfaßt.

12. Verfahren gemäß Anspruch 11, wobei der aktive Wafer einen Stapel aus III-V-Materialien umfaßt.

13. Verfahren gemäß Anspruch 11 oder 12, wobei Schritt d1 durch Zusammenfügen durch molekulare Adhäsion erhalten wird.

14. Verfahren gemäß einem der Ansprüche 11 bis 13, wobei die optisch aktiven Mittel (70) durch Ätzen in dem aktiven Wafer hergestellt werden.

15. Optoelektronisches Bauelement umfassend Mittel (66) zur Lichtleitung, die zwischen den Mitteln (68) einer elektronischen Schaltung und den optisch aktiven Mitteln (70) eingeschlossen sind, und eine Oxidzwischenschicht (62) mit einem Brechungsindex unter dem Index des die Mittel zur Lichtleitung bildenden Materials, die zwischen diesen Mitteln (66) zur Lichtleitung und den optisch aktiven Mitteln (70) eingeschlossen ist, **dadurch gekennzeichnet, daß** die Dicke der Oxidschicht zwischen 50 nm und 1 µm liegt, um das Sicherstellen einer guten elektromagnetischen Kopplung zwischen den Mitteln (66) zur Lichtleitung und den optisch aktiven Mitteln (70) zu ermöglichen.

16. Bauelement gemäß Anspruch 15, wobei der Index der Zwischenschicht unter 1,6 ist.

17. Bauelement gemäß Anspruch 15 oder 16, wobei das Oxid der Zwischenschicht ein thermisches Oxid ist.

18. Bauelement gemäß einem der Ansprüche 15 bis 17, wobei die Zwischenschicht eine Dicke zwischen 50 nm und 400 nm aufweist.

19. Bauelement gemäß einem der Ansprüche 15 bis 18, wobei die Mittel zur Lichtleitung und die Mittel (68) einer elektronischen Schaltung ein Abstand von mindestens 1 µm trennt.

20. Bauelement gemäß einem der Ansprüche 15 bis 19, wobei die optisch aktiven Mittel (70) aus Materialien des III-V-Typs bestehen.
